# EUROPÄISCHE PATENTSCHRIFT

(11) **EP 4 037 137 B1**
(45) Veröffentlichungstag und Bekanntmachung des Hinweises auf die Patenterteilung: **07.10.2026**
(21) Anmeldenummer: 21154433.3
(22) Anmeldetag: 29.01.2021
(51) Int. Cl.: H02J 7/00, G01R 31/327, H02H 11/00, G01R 31/26, H02J 7/56, H02J 7/60

(54) **LADEGERÄT**
CHARGING DEVICE
CHARGEUR

(43) Veröffentlichungstag der Anmeldung: 03.08.2022
(73) Patentinhaber: Andreas Stihl AG & Co. KG, 71336 Waiblingen (DE)
(72) Erfinder: Mattheis, Leonard, 71336 Waiblingen (DE); Grobe, Christian, 25524 Itzehoe (DE); Rastetter, Tobias Frank, 25421 Pinneberg (DE); Jakubietz, Nils, 25712 Burg (Dithmarschen) (DE)
(74) Vertreter: Patentanwälte Ruff, Wilhelm, Beier, Dauster & Partner mbB

(56) Entgegenhaltungen:
- EP-A2- 1 921 727
- DE-U1- 202014 106 185
- JP-A- S6 264 291
- US-A1- 2003 184 263
- US-A1- 2007 210 751
- US-A1- 2012 299 533

## Beschreibung

Der Erfindung liegt die Aufgabe zugrunde, ein Ladegerät mit einer Mehrzahl von elektrischen Schnittstellen zur Verfügung zu stellen, das eine hohe Betriebssicherheit aufweist und kostengünstig herstellbar ist.

Die EP 1 921 727 A2 offenbart ein Ladegerät mit einer Mehrzahl von elektrischen Schnittstellen, wobei eine jeweilige elektrische Schnittstelle zwei Feldeffekttransistoren aufweist, die antiseriell zwischen einen ersten Anschlusspol einer jeweiligen Schnittstelle und eine gemeinsame Ladeleitung eingeschleift sind.

Die US 2003/0184263 A1 offenbart ein Ladegerät mit einer Mehrzahl von elektrischen Schnittstellen.

Die US 2012/0299533 A1 offenbart eine Schaltung sowie ein Verfahren, die es ermöglichen, ein Ladegerät zwischen mehreren Batterien zu teilen.

Die JP S62 64291 A offenbart eine Prüfeinrichtung für zwei in Reihe geschaltete Schalter.

Das Ladegerät weist eine Mehrzahl von elektrischen Schnittstellen oder sogenannten Lade-Slots auf. Das Ladegerät kann beispielsweise zwischen zwei und acht Schnittstellen bzw. Lade-Slots aufweisen.

Eine jeweilige elektrische Schnittstelle ist bestimmungsgemäß mit einem aufzuladenden elektrischen Energiespeicher, beispielsweise in Form eines Akkus, zum Laden des aufzuladenden elektrischen Energiespeichers koppelbar.

Das Ladegerät weist weiter eine gemeinsame elektrische Ladeleitung auf, die im Lade-Betrieb des Ladegeräts ein Ladepotential führt, insbesondere ein gegenüber einem Bezugspotential positives Ladepotential führt.

Eine jeweilige elektrische Schnittstelle weist einen ersten Anschlusspol auf, der bestimmungsgemäß mit einem korrespondierenden ersten Anschlusspol eines aufzuladenden elektrischen Energiespeichers elektrisch zu verbinden ist. Typisch weist eine jeweilige elektrische Schnittstelle weiter einen zweiten Anschlusspol auf, der bestimmungsgemäß mit einem korrespondierenden zweiten Anschlusspol des aufzuladenden elektrischen Energiespeichers elektrisch zu verbinden ist. Am ersten Anschlusspol liegt typisch ein höheres Potential als am zweiten Anschlusspol an. Eine Potentialdifferenz zwischen erstem und zweitem Anschlusspol ist typisch die Ladespannung, die beispielsweise in einem Spannungsbereich zwischen 5 V und 80 V liegen kann.

Eine jeweilige elektrische Schnittstelle weist weiter genau zwei Feldeffekttransistoren auf, die antiseriell zwischen den ersten Anschlusspol und die gemeinsame Ladeleitung ohne oder gemeinsam mit weiteren elektrischen Bauelementen eingeschleift sind.

Das Ladegerät weist weiter mindestens eine Steuereinheit auf, beispielsweise in Form eines Mikroprozessors. Die Steuereinheit ist dazu ausgebildet, die beiden Feldeffekttransistoren einer jeweiligen elektrischen Schnittstelle derart anzusteuern, dass zu einem Zeitpunkt der erste Anschlusspol nur einer einzigen der elektrischen Schnittstellen über deren beide Feldeffekttransistoren mit der gemeinsamen Ladeleitung elektrisch verbunden ist, um einen Kurzschluss zwischen mehreren zu ladenden elektrischen Energiespeichern zu verhindern. Das Ladegerät kann eine einzelne Steuereinheit aufweisen, die den Betrieb aller Schnittstellen steuert. Alternativ kann jede Schnittstelle eine eigene Steuereinheit aufweisen, die den Betrieb der zugehörigen Schnittstelle steuert, wobei die Steuereinheiten untereinander verbunden sein können, um den Betrieb der Steuereinheiten zu synchronisieren.

Eine jeweilige elektrische Schnittstelle weist weiter eine Prüfeinrichtung auf, die dazu ausgebildet ist, eine ordnungsgemäße Schaltfunktion der beiden Feldeffekttransistoren zu überprüfen. Die Prüfeinrichtung kann in Soft- und/oder Hardware ausgeführt sein.

Die Prüfeinrichtung weist eine Spannungsmesseinrichtung auf, die dazu ausgebildet ist, eine Spannung an einem Verbindungsknoten der beiden Feldeffekttransistoren zu messen. Die Prüfeinrichtung ist dazu ausgebildet, eine gemessene Spannung mit einer zu erwartenden Spannung zu vergleichen, wobei sich die zu erwartenden Spannung bei einer ordnungsgemäßen Schaltfunktion der beiden Feldeffekttransistoren und einem vorgegebenen Schaltzustand der beiden Feldeffekttransistoren an dem Verbindungsknoten einstellen müsste. Eine ordnungsgemäßen Schaltfunktion der beiden Feldeffekttransistoren wird dann festgestellt, wenn die gemessene Spannung der zu erwartenden Spannung entspricht. Die zu erwartende Spannung kann ein absoluter Spannungswert sein oder auch einem Spannungsverhältnis entsprechen.

Die Prüfeinrichtung weist eine erste Testspannungserzeugungseinrichtung auf, die dazu ausgebildet ist, den ersten Anschlusspol mit einem ersten Prüfpotential zu beaufschlagen, und zwar insbesondere nur dann, wenn die zugehörige elektrische Schnittstelle nicht mit einem aufzuladenden elektrischen Energiespeicher gekoppelt ist, und/oder das Ladegerät weist eine zweite Testspannungserzeugungseinrichtung auf, die dazu ausgebildet ist, die Ladeleitung mit einem zweiten Prüfpotential zu beaufschlagen, und zwar insbesondere nur dann, wenn das Ladegerät auf der gemeinsamen Ladeleitung außerhalb des Lade-Betriebs des Ladegeräts kein, insbesondere positives, Ladepotential erzeugt.

Das korrekte Erzeugen des ersten und/oder zweiten Prüfpotentials kann mit einer hierfür vorgesehenen Spannungsmesseinrichtung des Ladegeräts erfolgen.

In einer Ausführungsform beträgt die erwartete Spannung 0 Volt, wenn beide Feldeffekttransistoren einer jeweiligen Schnittstelle geöffnet sind.

In einer Ausführungsform weist die Prüfeinrichtung ein ansteuerbares Schaltmittel und einen Prüfwiderstand auf, wobei das ansteuerbare Schaltmittel und der Prüfwiderstand in Reihe zwischen den ersten Anschlusspol und den Verbindungsknoten der beiden Feldeffekttransistoren eingeschleift sind.

In einer Ausführungsform ist die Prüfeinrichtung dazu ausgebildet, während einer Prüfung und wenn beide Feldeffekttransistoren geöffnet sind das ansteuerbare Schaltmittel zu schließen, wobei die erwartete Spannung dann von der an dem ersten Anschlusspol anstehenden Spannung abhängig ist, beispielsweise der an dem ersten Anschlusspol anstehenden Spannung entspricht.

Die Erfindung wird nachfolgend unter Bezugnahme auf die Zeichnung detailliert beschrieben. Hierbei zeigt:

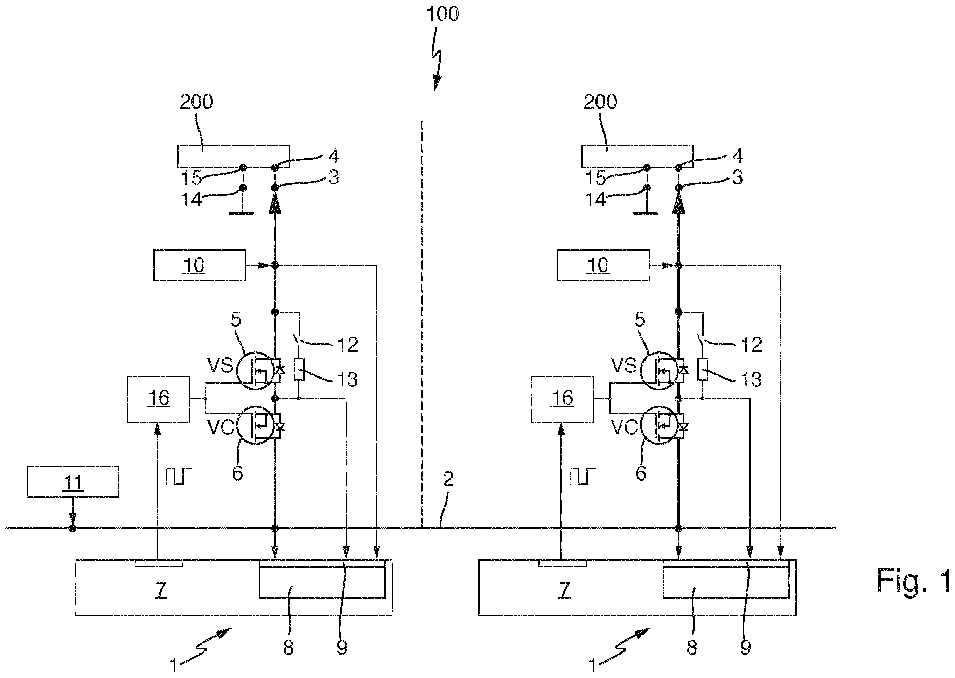

- Fig. 1: ein Blockschaltbild eines erfindungsgemäßen Ladegeräts mit einer Mehrzahl von elektrischen Schnittstellen, wobei eine jeweilige elektrische Schnittstelle mit einem aufzuladenden elektrischen Energiespeicher zum Laden des Energiespeichers koppelbar ist.

Fig. 1 zeigt ein Ladegerät 100 mit einer Mehrzahl von elektrischen Schnittstellen oder Lade-Slots 1, wobei eine jeweilige elektrische Schnittstelle 1 mit einem aufzuladenden elektrischen Energiespeicher 200, beispielsweise in Form eines Akkus, zum Laden des aufzuladenden elektrischen Energiespeichers koppelbar ist. Vorliegend sind exemplarisch zwei Schnittstellen 1 dargestellt. Es versteht sich, dass das Ladegerät 100 auch mehr als zwei Schnittstellen 1 aufweisen kann, beispielsweise vier oder acht Schnittstellen 1.

Zum Laden des elektrischen Energiespeichers 200 wird dieser elektrisch mit der zugehörigen Schnittstelle 1 gekoppelt, indem er beispielsweise in einen Lade-Schacht der Schnittstelle 1 eingeführt wird. Es versteht sich, dass die Schnittstelle 1 weitere nicht gezeigte Bauelemente aufweisen kann, beispielsweise Steckverbinder, Buchsen, etc. Insoweit sei auch auf die einschlägige Fachliteratur verwiesen.

Das Ladegerät weist weiter eine gemeinsame Ladeleitung 2 auf, die im Lade-Betrieb des Ladegeräts 100 ein gegenüber einem Bezugspotential positives Ladepotential führt.

Eine jeweilige elektrische Schnittstelle 1 weist einen ersten Anschlusspol 3 auf, der bestimmungsgemäß mit einem korrespondierenden ersten Anschlusspol 4 eines aufzuladenden elektrischen Energiespeichers 200 elektrisch zu verbinden ist.

Eine jeweilige elektrische Schnittstelle 1 weist weiter einen zweiten Anschlusspol 14 auf, der bestimmungsgemäß mit einem korrespondierenden zweiten Anschlusspol 15 des aufzuladenden elektrischen Energiespeichers 200 elektrisch zu verbinden ist. An dem zweiten Anschlusspol 14 kann beispielsweise ein Bezugspotential ausgegeben werden, so dass zwischen den Anschlusspolen 3 und 14 eine geeignete Ladespannung bzw. ein geeigneter Ladestrom ausgegeben wird.

Eine jeweilige elektrische Schnittstelle 1 weist weiter zwei (MOS-) Feldeffekttransistoren, d.h. MOSFETs, 5 und 6 auf, die antiseriell zwischen den ersten Anschlusspol 3 und die gemeinsame Ladeleitung 2 eingeschleift sind.

Das Ladegerät 100 weist weiter pro Schnittstelle 1 eine Steuereinheit 7 auf, die dazu ausgebildet ist, die beiden Feldeffekttransistoren 5 und 6 der zugehörigen Schnittstelle 1 derart anzusteuern, dass zu einem Zeitpunkt der erste Anschlusspol 3 nur einer einzigen der elektrischen Schnittstellen 1 über deren beide Feldeffekttransistoren 5 und 6 mit der gemeinsamen Ladeleitung 2 elektrisch verbunden ist.

Wie dargestellt weist jede Schnittstelle 1 eine zugehörige Steuereinheit 7 auf. Alternativ kann eine einzelne Steuereinheit vorgesehen sein, die den Betrieb aller Schnittstellen 1 steuert. Die dargestellten Steuereinheiten 7 sind für diesen Fall Bestandteile einer gemeinsamen, übergeordneten Steuereinheit und bilden dann einzelne Steuereinheit-Module.

Die Steuereinheit 7 einer jeweiligen elektrischen Schnittstelle 1 steuert über einen Treiber 16 die beiden Feldeffekttransistoren 5 und 6 geeignet an, so dass diese bei ordnungsgemäßer Funktion einen gewünschten Schaltzustand annehmen.

Eine elektrische Schnittstelle 1 weist eine Prüfeinrichtung 8 auf, die dazu ausgebildet ist, eine ordnungsgemäße Schaltfunktion der beiden Feldeffekttransistoren 5 und 6 zu überprüfen. Die Prüfeinrichtung 8 ist vorliegend Bestandteil der Steuereinheit 7. Die Prüfeinrichtung 8 kann jedoch auch getrennt von der Steuereinheit 7 realisiert sein.

Die Prüfeinrichtung 8 weist eine Spannungsmesseinrichtung 9 auf, die dazu ausgebildet ist, eine Spannung an einem Verbindungsknoten der beiden Feldeffekttransistoren 5 und 6 zu messen. Die Spannungsmesseinrichtung 9 ist weiter dazu ausgebildet, eine Spannung am Anschlusspol 3 und eine Spannung auf der gemeinsamen Ladeleitung 2 zu messen.

Die Prüfeinrichtung 8 ist dazu ausgebildet, eine an dem Verbindungsknoten der beiden Feldeffekttransistoren 5 und 6 gemessene Spannung mit einer erwarteten Spannung zu vergleichen, die sich bei vorgegebenem Schaltzustand der Feldeffekttransistoren 5 und 6 und bei einer ordnungsgemäßen Schaltfunktion der beiden Feldeffekttransistoren 5 und 6 an dem Verbindungsknoten einstellt, wobei eine ordnungsgemäßen Schaltfunktion der beiden Feldeffekttransistoren 5 und 6 festgestellt wird, wenn die gemessene Spannung der erwarteten Spannung entspricht.

Die Prüfeinrichtung 8 weist weiter eine erste Testspannungserzeugungseinrichtung 10 auf, die dazu ausgebildet ist, den ersten Anschlusspol 3 mit einem ersten Prüfpotential zu beaufschlagen, falls kein elektrischer Energiespeicher 200 mit der entsprechenden Schnittstelle 1 gekoppelt ist.

Das Ladegerät 100 weist weiter eine zweite Testspannungserzeugungseinrichtung 11 auf, die dazu ausgebildet ist, die Ladeleitung 2 mit einem zweiten Prüfpotential zu beaufschlagen, falls auf der gemeinsamen Ladeleitung 2 außerhalb des Lade-Betriebs des Ladegeräts 100 kein positives Ladepotential erzeugt wird.

Die Prüfeinrichtung 8 weist weiter ein ansteuerbares Schaltmittel 12 und einen Prüfwiderstand 13 auf, wobei das ansteuerbare Schaltmittel 12 und der Prüfwiderstand 13 in Reihe zwischen den ersten Anschlusspol 3 und den Verbindungsknoten der beiden Feldeffekttransistoren 5 und 6 eingeschleift sind.

Ein typischer Prüfablauf wird nachfolgend detailliert beschrieben.

Um die notwendige funktionale Sicherheit zu gewährleisten, werden die Feldeffekttransistoren 5 und 6 ständig überwacht. Hierzu wird eine Spannung am Mittelabgriff bzw. Verbindungsknoten der Feldeffekttransistoren 5 und 6 gemessen.

Die erwartete Spannung am Verbindungsknoten der Feldeffekttransistoren 5 und 6 beträgt 0 V, solange beide Feldeffekttransistoren 5 und 6 sperren. Beträgt die gemessene Spannung am Verbindungsknoten der Feldeffekttransistoren 5 und 6 nicht 0 V, kann auf einen Fehler geschlossen werden und eine entsprechende Fehlerbehandlung kann eingeleitet werden, die das Ladegerät 100 in einen sicheren Zustand überführt.

Die Überprüfung wird beispielsweise immer vor dem Beginn eines Aufladens eines elektrischen Energiespeichers 200 durchgeführt. Weiter kann die Überprüfung für diejenigen Schnittstellen 1 zyklisch erfolgen, die sich momentan nicht im Lade-Betrieb befinden. Eine Überprüfung für eine Schnittstelle 1 die sich im Lade-Betrieb befindet ist nicht zwingend notwendig, da deren beide Feldeffekttransistoren 5 und 6 leitend sind.

Um auszuschließen, dass die am Verbindungsknoten der Feldeffekttransistoren 5 und 6 gemessene Spannung nur deshalb 0 V beträgt, da am Knoten 3 und auf der gemeinsamen Ladeleitung 2 momentan keine oder eine identische Spannung ansteht, wird erfindungsgemäß sichergestellt, dass während der Überprüfung immer eine Spannung an der Reihenschaltung der Feldeffekttransistoren 5 und 6 abfällt.

Falls ein Energiespeicher 200 an der Schnittstelle 1 angeschlossen ist, kann dieser für ein geeignetes Potential am Anschlusspol 3 sorgen. Dies wird mittels der Spannungsmesseinrichtung 9 überprüft. Reicht die Spannung bzw. das Potential nicht aus, da beispielsweise kein Energiespeicher 200 an die Schnittstelle 1 angeschlossen ist oder der Energiespeicher 200 keine ausreichende Spannung erzeugt, wird mittels der ersten Testspannungserzeugungseinrichtung 10 am ersten Anschlusspol 3 durch kapazitive Einkopplung ein erstes Prüfpotential erzeugt.

Im Lade-Betrieb stellt das Ladegerät 100 das Lade-Potential auf der gemeinsamen Ladeleitung 2 zur Verfügung. Außerhalb des Lade-Betriebs wird mittels der zweiten Testspannungserzeugungseinrichtung 11 auf der gemeinsamen Lade-Leitung 2 ein zweites Prüfpotential eingeprägt.

Die mittels der ersten Testspannungserzeugungseinrichtung 10 bzw. der zweiten Testspannungserzeugungseinrichtung 11 erzeugten Prüf-Spannungen bzw. Prüf-Potentiale werden mittels der Spannungsmesseinrichtung 9 gemessen und im Hinblick darauf geprüft, ob sie zur Funktionsüberprüfung der Feldeffekttransistoren 5 und 6 geeignet sind.

Die Spannungsmessung am Verbindungsknoten der Feldeffekttransistoren 5 und 6 wird zusätzlich plausibilisiert, um die ordnungsgemäße Funktion der Spannungsmessung selbst sicherzustellen.

Dazu wird das ansteuerbare Schaltmittel 12 geschlossen und damit hochohmig eine Spannung in den Verbindungsknoten der Feldeffekttransistoren 5 und 6 eingeprägt. Die eingeprägte Spannung wird dabei so gering gewählt, dass auch in einem Einfachfehler, d.h. beispielsweise einem Kurzschluss in einer anderen Schnittstelle 1, kein Energiespeicher 200 unbeabsichtigt geladen werden kann.

Nach dem Schließen des Schaltmittels 12 werden die am Anschlusspol 3 gemessene Spannung und die am Verbindungsknoten der Feldeffekttransistoren 5 und 6 gemessene Spannung miteinander verglichen. Falls der Vergleich nicht das gewünschte Ergebnis liefert, ist von einem Fehler der Spanungsmessung und/oder von einem Fehler der Feldeffekttransistoren auszugehen und das Ladegerät 100 wird in einen sicheren Zustand überführt. Damit kann sichergestellt werden, dass das Überprüfen der Schaltfunktion der beiden Feldeffekttransistoren 5 und 6 mittels Spannungsmessung am Verbindungsknoten ordnungsgemäß funktioniert.

Erfindungsgemäß können Redundanzen reduziert werden, da beispielsweise die notwendige funktionale Sicherheit bereits durch Verwendung von nur zwei antiseriell geschalteten MOSFETs pro Schnittstelle erzielt werden kann. Durch die erfindungsgemäße ständige Überwachung der ordnungsgemäßen Funktion der MOSFETs sind keine weiteren Schalter im Ladepfad notwendig.

## Patentansprüche

1. Ladegerät (100), aufweisend:
- eine Mehrzahl von elektrischen Schnittstellen (1), wobei eine jeweilige elektrische Schnittstelle (1) mit einem aufzuladenden elektrischen Energiespeicher (200) zum Laden des aufzuladenden elektrischen Energiespeichers (200) koppelbar ist,
- eine gemeinsame Ladeleitung (2), die im Lade-Betrieb des Ladegeräts (100) ein, insbesondere positives, Ladepotential führt,
- wobei eine jeweilige elektrische Schnittstelle (1) aufweist:
- einen ersten Anschlusspol (3), der bestimmungsgemäß mit einem korrespondierenden Anschlusspol (4) eines aufzuladenden elektrischen Energiespeichers (200) elektrisch zu verbinden ist, und
- zwei Feldeffekttransistoren (5, 6), die antiseriell zwischen den ersten Anschlusspol (3) und die gemeinsame Ladeleitung (2) eingeschleift sind, und
- mindestens eine Steuereinheit (7), die dazu ausgebildet ist, die beiden Feldeffekttransistoren (5, 6) einer jeweiligen elektrischen Schnittstelle (1) derart anzusteuern, dass zu einem Zeitpunkt der erste Anschlusspol (3) nur einer einzigen elektrischen Schnittstelle (1) über deren beide Feldeffekttransistoren (5, 6) mit der gemeinsamen Ladeleitung (2) elektrisch verbunden ist,
**dadurch gekennzeichnet, dass**
- eine jeweilige elektrische Schnittstelle (1) aufweist:
- eine Prüfeinrichtung (8), die dazu ausgebildet ist, eine ordnungsgemäße Schaltfunktion der beiden Feldeffekttransistoren (5, 6) zu überprüfen,
- wobei die Prüfeinrichtung (8) eine Spannungsmesseinrichtung (9) aufweist, die dazu ausgebildet ist, eine Spannung an einem Verbindungsknoten der beiden Feldeffekttransistoren (5, 6) zu messen, wobei die Prüfeinrichtung (8) dazu ausgebildet ist, eine gemessene Spannung mit einer erwarteten Spannung zu vergleichen, die sich bei einer ordnungsgemäßen Schaltfunktion der beiden Feldeffekttransistoren (5, 6) an dem Verbindungsknoten einstellt, wobei eine ordnungsgemäßen Schaltfunktion der beiden Feldeffekttransistoren (5, 6) festgestellt wird, wenn die gemessene Spannung der erwarteten Spannung entspricht, und
- wobei die Prüfeinrichtung (8) eine erste Testspannungserzeugungseinrichtung (10) aufweist, die dazu ausgebildet ist, den ersten Anschlusspol (3) mit einem ersten Prüfpotential zu beaufschlagen, und/oder wobei das Ladegerät (100) eine zweite Testspannungserzeugungseinrichtung (11) aufweist, die dazu ausgebildet ist, die Ladeleitung (2) mit einem zweiten Prüfpotential zu beaufschlagen.

2. Ladegerät (100) nach Anspruch 1, **dadurch gekennzeichnet, dass**
- die erwartete Spannung 0 V beträgt, wenn beide Feldeffekttransistoren (5, 6) einer jeweiligen Schnittstelle geöffnet sind.

3. Ladegerät (100) nach einem der vorhergehenden Ansprüche, **dadurch gekennzeichnet, dass**
- die Prüfeinrichtung (8) ein ansteuerbares Schaltmittel (12) und einen Prüfwiderstand (13) aufweist, wobei das ansteuerbare Schaltmittel (12) und der Prüfwiderstand (13) in Reihe zwischen den ersten Anschlusspol (3) und den Verbindungsknoten der beiden Feldeffekttransistoren (5, 6) eingeschleift sind.

4. Ladegerät (100) nach Anspruch 3, **dadurch gekennzeichnet, dass**
- die Prüfeinrichtung (8) dazu ausgebildet ist, während einer Prüfung und wenn beide Feldeffekttransistoren (5, 6) geöffnet sind das ansteuerbare Schaltmittel (12) zu schließen, wobei die erwartete Spannung dann von der an dem ersten Anschlusspol (3) anstehenden Spannung abhängig ist.

## Claims

1. Charger (100), comprising:
- a plurality of electrical interfaces (1), wherein a respective electrical interface (1) is able to be coupled to an electrical energy store (200) to be charged, for the purposes of charging the electrical energy store (200) to be charged,
- a common charge line (2) which carries a charging potential, in particular a positive charging potential, during the charging operation of the charger (100),
- wherein a respective electrical interface (1) includes:
- a first connection terminal (3) which, when used as intended, is to be electrically connected to a corresponding connection terminal (4) of an electrical energy store (200) to be charged, and
- two field-effect transistors (5, 6) which are looped-in in anti-serial fashion between the first connection terminal (3) and the common charge line (2), and
- at least one control unit (7) which is designed to drive the two field-effect transistors (5, 6) of a respective electrical interface (1) such that, at any one time, the first connection terminal (3) of only a single electrical interface (1) is electrically connected to the common charge line (2) via its two field-effect transistors (5, 6),
**characterized in that**
- a respective electrical interface (1) includes:
- a test device (8) which is designed to check a correct switching function of both field-effect transistors (5, 6),
- wherein the test device (8) has a voltage measuring device (9) which is designed to measure a voltage at a connection node of the two field-effect transistors (5, 6), wherein the test device (8) is designed to compare a measured voltage to an expected voltage which sets in at the connection node in the case of a correct switching function of the two field-effect transistors (5, 6), a correct switching function of the two field-effect transistors (5, 6) being determined if the measured voltage corresponds to the expected voltage, and
- wherein the test device (8) has a first test voltage generation device (10) which is embodied to apply a first test potential to the first connection terminal (3), and/or wherein the charger (100) comprises a second test voltage generation device (11) which is embodied to apply a second test potential to the charge line (2).

2. Charger (100) according to Claim 1, **characterized in that**
- the expected voltage is 0 V if both field-effect transistors (5, 6) of a respective interface are open.

3. Charger (100) according to one of the preceding claims, **characterized in that**
- the test device (8) has a driveable switching means (12) and a test resistor (13), wherein the driveable switching means (12) and the test resistor (13) are looped-in in series between the first connection terminal (3) and the connection node of the two field-effect transistors (5, 6).

4. Charger (100) according to Claim 3, **characterized in that**
- the test device (8) is designed to close the driveable switching means (12) during a test and when both field-effect transistors (5, 6) are open, with the expected voltage then depending on the voltage present at the first connection terminal (3).

## Revendications

1. Chargeur (100), comprenant :
- une pluralité d'interfaces électriques (1), une interface électrique (1) respective pouvant être couplée à un accumulateur d'énergie électrique (200) à recharger afin de charger l'accumulateur d'énergie électrique (200) à recharger,
- un câble de charge (2) commun qui, dans le mode de charge du chargeur (100), amène un potentiel de charge, notamment positif,
- une interface électrique (1) respective possédant :
- un premier pôle de raccordement (3) qui, conformément à sa destination, doit être connecté électriquement à un pôle de raccordement (4) correspondant d'un accumulateur d'énergie électrique (200) à recharger, et
- deux transistors à effet de champ (5, 6) qui sont insérés en anti-série entre le premier pôle de raccordement (3) et le câble de charge (2) commun, et
- au moins une unité de commande (7), qui est configurée pour piloter les deux transistors à effet de champ (5, 6) d'une interface électrique (1) respective de telle sorte qu'à un moment donné, le premier pôle de raccordement (3) d'une seule et unique interface électrique (1) soit relié électriquement au câble de charge (2) commun par le biais de ses deux transistors à effet de champ (5, 6),
**caractérisé en ce que**
- une interface électrique (1) respective possède :
- un dispositif d'essai (8), qui est configuré pour vérifier une fonction de commutation correcte des deux transistors à effet de champ (5, 6),
- le dispositif d'essai (8) possédant un dispositif de mesure de tension (9) qui est configuré pour mesurer une tension au niveau d'un nœud de connexion des deux transistors à effet de champ (5, 6), le dispositif d'essai (8) étant configuré pour comparer une tension mesurée avec une tension attendue qui s'établit au niveau du nœud de connexion dans le cas d'une fonction de commutation correcte des deux transistors à effet de champ (5, 6), une fonction de commutation correcte des deux transistors à effet de champ (5, 6) étant constatée lorsque la tension mesurée correspond à la tension attendue, et
- le dispositif d'essai (8) possédant un premier dispositif de génération de tension d'essai (10) qui est configuré pour appliquer un premier potentiel d'essai au premier pôle de raccordement (3) et/ou où le chargeur (100) possédant un deuxième dispositif de génération de tension d'essai (11) qui est configuré pour appliquer un deuxième potentiel d'essai au câble de charge (2).

2. Chargeur (100) selon la revendication 1, **caractérisé en ce que**
- la tension attendue est de 0 V lorsque les deux transistors à effet de champ (5, 6) d'une interface respective sont ouverts.

3. Chargeur (100) selon l'une des revendications précédentes, **caractérisé en ce que**
- le dispositif d'essai (8) possède un dispositif de commande (12) commandable et une résistance d'essai (13), le dispositif de commande (12) commandable et la résistance d'essai (13) étant insérés en série entre le premier pôle de raccordement (3) et les nœuds de connexion des deux transistors à effet de champ (5, 6).

4. Chargeur (100) selon la revendication 3, **caractérisé en ce que**
- le dispositif d'essai (8) est configuré pour fermer le dispositif de commutation (12) pendant un essai et lorsque les deux transistors à effet de champ (5, 6) sont ouverts, la tension attendue étant alors dépendante de la tension présente au niveau du premier pôle de raccordement (3).
